# NEW EUROPEAN PATENT SPECIFICATION

(11) **EP 2 831 423 B2**
(45) Date of publication and mention of the opposition decision: **26.07.2023**
(45) Mention of the grant of the patent: 01.07.2020
(21) Application number: 13724324.2
(22) Date of filing: 20.03.2013
(51) Int. Cl.: F04C 25/02, F04C 29/00

(54) **VACUUM PUMP SYSTEM**
VAKUUMPUMPSYSTEM
SYSTÈME DE POMPES À VIDE

(30) Priority: 26.03.2012 GB 201205284
(43) Date of publication of application: 04.02.2015
(73) Proprietor: Edwards Limited, Burgess Hill West Sussex RH15 9TW (GB)
(72) Inventor: MANSON, David Paul, Shoreham By Sea Sussex BN43 6PB (GB)
(74) Representative: Norton, Ian Andrew
(86) International application number: PCT/GB2013/050719
(87) International publication number: WO 2013/144581

(56) References cited:
- WO-A1-2006/095132
- WO-A1-2007/036689
- FR-A1- 2 916 022
- US-A- 6 022 195
- US-A1- 2003 219 342

## Description

### FIELD OF THE INVENTION

The present invention relates to apparatus for supplying a purge gas to a multistage vacuum pump.

### BACKGROUND OF THE INVENTION

Vacuum pumps are used in many industrial applications, such as steel manufacture, refining, scientific instruments and semiconductor or electronic component manufacture (including, but not limited to Li-ion battery production, solar cell, transistor, integrated circuits and flat panel display manufacture). The present invention is described below with reference to semiconductor manufacture, but it is understood that the invention is not limited to vacuum pumps used exclusively in this field.

Vacuum pumps used to pump fluid from semiconductor tools typically employ, as a backing pump, a multistage positive displacement pump. Such a semiconductor vacuum pump generally has a number of pumping stages that progressively compress the process gas until exhausting it at slightly above atmospheric pressure. Purge gas is also progressively introduced into the pump stages in proportion to the compression ratio of the particular pump stage.

During semiconductor processes such as chemical vapour deposition processing, deposition gases are supplied to a process chamber to form a deposition layer on the surface of a substrate. As the residence time in the chamber of the deposition gas is relatively short, only a small proportion of the gas supplied to the chamber is consumed during the deposition process. Consequently, unconsumed gas molecules pumped from the chamber by a vacuum pump can pass through the pump in a highly reactive state. As a result, pump components can be subjected to damage due to corrosion and degradation resulting from the pumping of the aggressive, unconsumed gas molecules.

To dilute process gases as they pass through the pump, an inert purge gas, such as nitrogen can be supplied to the pump. Nitrogen purge is recommended for many vacuum dry pumps used in the flat panel and semiconductor industry for reasons of safety, reliability and performance. Introducing the purge progressively through the pump mechanism stages provides the optimum combination of effectiveness and performance. The quantity of purge gas must be carefully controlled to avoid both under-dilution of the process gases, as this could lead to pumping reliability problems, and over-dilution of the process gases, as this could lead to unnecessary costs and loss of pumping performance.

It is known to have flow selector apparatus that typically consist of a pressurised manifold or pipe arrangement with a number of outlets through which the purge gas can enter the pump mechanism. WO 2007/107781 describes a flow selector capable of varying the flow rate of gas into and from the flow selector. The outlets each have an aperture sized to provide a known flow rate dependant on the manifold pressure. The manifold is rotated to couple a manifold inlet to different sets of outlets. Such a device supplies a fixed amount of purge according the selected amount.

Moreover, there are occasions when for environmental and economic reasons it is desirable to minimise the nitrogen consumption. Step changes in the gas purge flow rates can be achieved by opening or closing the actuation valves in various combinations. For a multistage pump this could require a large number of valves. It is also likely that the resulting purge rate combination would not be ideally matched to the process gas flow. Alternatively, manual adjustment of the restrictors can be carried out. This is time consuming and requires individual measurement of each stage purge to ensure that the required purge level had been achieved.

WO 2007/036689 discloses a method of pumping a gas stream containing a light gas, such as hydrogen, and one or more condensable species, such as phosphorus vapour, ammonium chloride or polymeric vapours. The gas stream is conveyed to a multistage vacuum pump having a pump inlet and a pump exhaust. A purge gas supply system is provided for supplying purge gas, such as nitrogen, to the pump. The purge gas supply system comprises a manifold having an inlet and a plurality of outlets. Within the manifold, the stream of purge gas is split into a plurality of streams for conveyance to the outlets.

WO 2006/095132 discloses apparatus for inhibiting the propagation of a flame front ignited by a pumping mechanism of a vacuum pump. The vacuum pump draws a waste stream from a process chamber via a foreline. The vacuum pump is connected to an abatement system via a pipe. A purge system is provided for inducing quantities of inert gas into the vacuum pump. The purge system comprises one or more purge ports located along the length of the vacuum pump. A pressure detector is located within the foreline or at the inlet of the pump to provide a pressure signal to a controller. If the detected pressure in the foreline or at the inlet to the pump exceeds a predetermined pressure, the controller outputs an instruction to the purge system to flood the pump with inert gas to reduce the concentration of the flammable mixture.

The present invention seeks to address or ameliorate some of the shortcomings associated with known systems and processes.

### SUMMARY OF THE INVENTION

From one aspect, the present invention provides an apparatus for supplying a purge gas to a multistage vacuum pump according to claim 1.

The flow rates of the gas supplied to the ports have a fixed ratio, irrespective of the total flow rate through the apparatus. The flow rates in the outlets can be maintained in a fixed ratio relative to each other irrespective of the overall flow rate. By varying the gas flow rate and/or gas pressure at the gas inlet, the flow rate at the gas outlets can be increased or decreased. The control module can be configured to provide infinitely variable control of the gas flow to the gas inlet. The ratio of the gas flow rates to the plurality of gas outlets remain constant regardless of the flow rate or pressure at the inlet.

The orifices each have an effective size which determines the gas flow from the gas outlet to the respective port. The ratio of the effective sizes of the orifices is fixed. The effective size of each orifice can be defined by a restrictor. The restrictor can have a fixed size, for example a fixed diameter aperture.

The orifices can be sized to provide a nominal total flow at a particular pressure. As the upstream pressure varies the total flow varies as a total of the flow through the gas outlets. The flow through the separate gas outlets remain in the same fixed linear proportion to one another regardless of the overall flow rate.

The control module can be operable to adjust the pressure of gas supplied to the gas inlet. Alternatively, or in addition, the control module can be operable to adjust the flow rate through the gas inlet. For example, the control module can comprise a variable restrictor for varying the gas flow rate through the gas inlet.

The apparatus further comprises at least one sensor for generating the control signal. The at least one sensor is a pressure sensor in fluid communication with either the gas inlet or one of said gas outlets.

The control signal can be received from a processing tool upstream of the multistage pump; and/or a pump controller.

The present invention also relates to a pump system comprising the apparatus according to claims 1-5, the pump system further comprising:
a multistage pump having a pump inlet, a plurality of ports and a pump exhaust; and
a pump controller for controlling operation of the pump;
wherein the gas outlets from the apparatus are connected to respective ports of the multistage pump.

The control orifices can be sized to match the flow rate ratios for the respective gas outlets to the compression ratios of the various stages of a pump.

The multistage pump can be a vacuum pump or an abatement device.

The pump controller can be configured to output the control signal in response to one or more of the following:
a) a pressure sensor in fluid communication with the pump inlet; and
b) a pressure sensor in fluid communication with the pump exhaust.

The pump system can further comprise a processing tool, for example a chemical vapour deposition apparatus or similar semiconductor processing tool (as are well known by the person skilled in the art and thus need no further explanation). A tool controller can be provided for controlling the processing tool. A conduit, such as a foreline, can be provided in fluid communication with the pump inlet. The tool controller can generate the control signal in response to an operating mode of the processing tool.

In a further aspect, the present invention relates to a pump system as claimed in claim 6 or claim 7 further comprising a processing tool having a tool controller and a conduit in fluid communication with the pump inlet. In a further aspect, the present invention relates to a method for supplying a purge gas in a pump system, as defined in claim 10.

The controller according to the present invention has particular application for controlling the flow rate of purge gas for a vacuum pump.

### BRIEF DESCRIPTION OF THE DRAWINGS

A preferred embodiment of the present invention(s) will now be described, by way of example only, with reference to the accompanying Figures, in which:
Figure 1 shows a schematic overview of a pump system incorporating a purge gas system according to an embodiment of the present invention;
Figure 2 shows a schematic overview of a flow control system for the pump system illustrated in Figure 1; and
Figure 3 shows a graph of flow rates from outlets of the flow control system according to the present invention.

### DESCRIPTION OF A PREFERRED EMBODIMENT

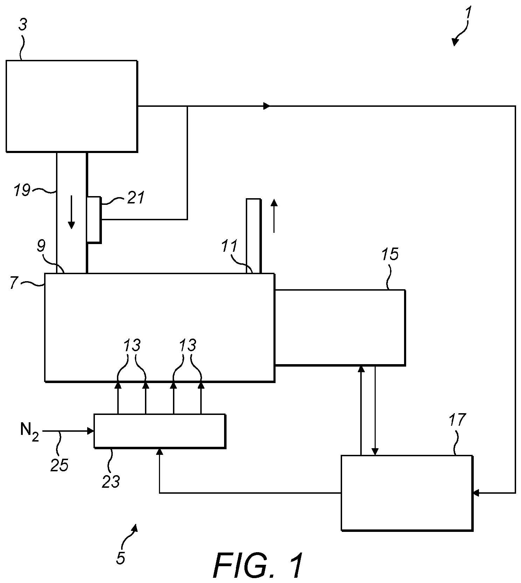

A schematic overview of a pump system 1 in fluid communication with a processing tool 3 is shown schematically in Figure 1. The pump system 1 is coupled to a variable purge system 5 operable in accordance with the present invention.

The vacuum pump system 1 comprises a multistage vacuum pump 7 having a pump inlet 9, a pump (exhaust) outlet 11 and a plurality of purge ports 13. An electric pump motor 15 drives the vacuum pump 7 in response to control signals from a system controller 17. The system controller 17 comprises a digital processor (not shown) configured to measure the operating current of the pump motor 15 to monitor the status of the vacuum pump 7.

In the present embodiment, the processing tool 3 is a chemical vapour deposition apparatus comprising a vacuum chamber (not shown), but of course the invention is not limited to CVD apparatus and can be applied to other processes or applications. The vacuum chamber is in fluid communication with the pump inlet 9 via a foreline 19. A gas sensor 21 is provided in the foreline 19 to detect the type of gas present in the pump inlet 9 and to output a corresponding gas detection signal to the system controller 17.

The variable purge system 5 comprises a manifold 23 having a purge gas inlet 25 and a plurality of purge gas outlets 27a-f. Operation of the manifold 23 is controlled by the system controller 17. Each purge gas outlet 27a-f is connected to a respective purge port 13a-f of the vacuum pump 7. In the present embodiment purge ports 13 are provided for the 3/4 interstage purge, 4/5 interstage purge, low vacuum (LV), shaft seal (SS), exhaust (Exh) and inlet stage of the vacuum pump 7. The purge gas in the present embodiment is nitrogen (N₂).

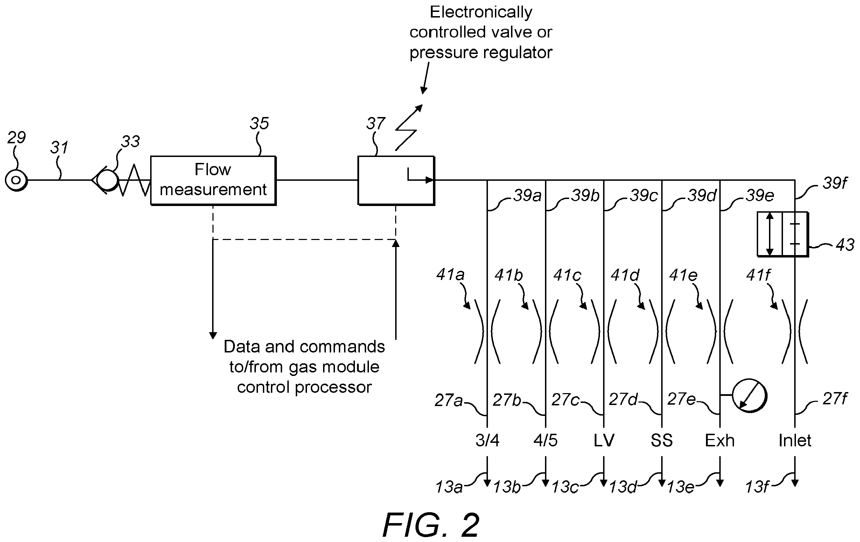

With reference to Figure 2, the purge gas inlet 25 is connected to a source 29 of the purge gas via a conduit 31, which includes a one-way valve 33. A flow measurement sensor 35 is provided in the conduit 31 to measure the actual total flow of purge gas supplied and to output a flow measurement signal to the system controller 17. An electronic control valve 37 is provided in the conduit 31 to provide a master controller for controlling the flow rate of purge gas supplied to the manifold 23. The system controller 17 compares the measured actual total flow with the required total flow and actuates the control valve 37 automatically to match the actual measured flow with the required flow. Feedback can optionally be provided between the flow measurement sensor 35 and the control valve 37, for example automatically to regulate pressure.

The adjustment of the control valve 37 causes a change in the downstream pressure of the purge gas. This is typically achieved by small movements of a valve stem or other mechanical component to increase or decrease the size of the valve seat, thereby altering the pressure drop across the valve. In the case of a pressure regulator, the changes can be implemented by altering the loading on the regulator diaphragm.

A plurality of purge lines 39a-f are defined within the manifold 23 to split the supply of purge gas into streams for conveyance to corresponding purge gas outlets 27a-f. A flow restrictor 41a-f having a fixed aperture is provided in each purge line 39a-f to provide a nominal flow at a particular purge gas pressure. The proportion of the purge gas supplied to each gas outlet 27a-f depends on the relative sizes of the apertures in the flow restrictors 41a-f. The size of the apertures in the flow restrictors 41a-f are fixed and, therefore, the gas flow rates to the purge gas outlets 27a-f are proportionally fixed. While the flow rate can be adjusted by the electronic control valve 37, the ratio of the flow rates in each of the outlets is maintained in a fixed relationship relative to one another. A solenoid valve 43 is provided to provide intermittent flow for a separate (inlet) pump stage. The same linear ratio is maintained for the separate pump stage to enable inlet purge rates to be matched, for example for auto-shutdown, and to mitigate dust ingestion.

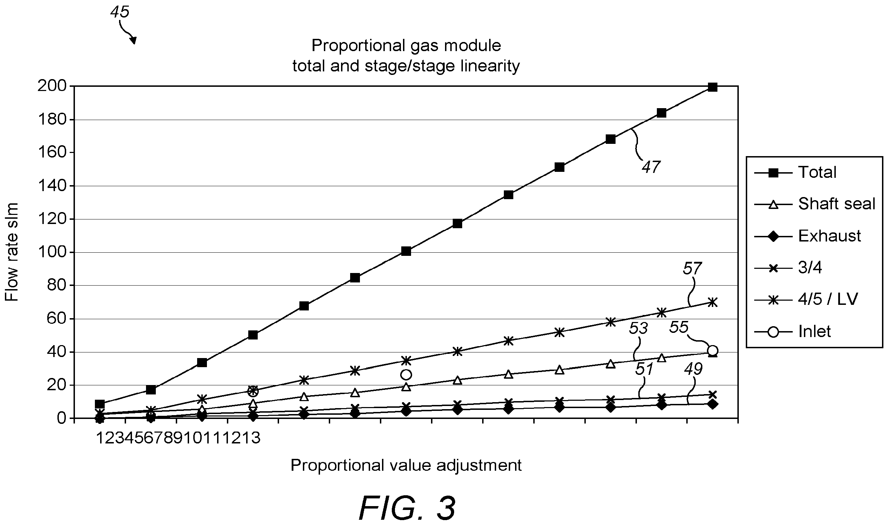

The fixed proportionality of the flow rates to the purge gas outlets 27a-f is illustrated in a chart 45 shown in Figure 3 for a range of flow rates at the purge gas inlet 25. The total flow rate through all of the purge ports 13 is illustrated by a first plot line 47. The flow rate for the purge ports 13 connected to the exhaust, the 3/4 interstage, the shaft seal, the inlet and the 4/5 interstage are illustrated in Figure 3 by respective second, third, fourth, fifth and sixth plot lines 49, 51, 53, 55, 57.

The variable purge system 5 controls the flow of purge gas to each pump stage in one of two ways, either: automatic adjustment of pressure upstream of the flow restrictors 41a-f; or automatic adjustment of a master orifice upstream of the flow restrictors 41a-f. Adjustment of the upstream pressure or master orifice reduces or increases the overall purge flow but maintains the flow rate to the purge gas outlets 27a-f proportionally fixed relative to each other. The electronic control valve 37 is actuated to adjust the purge gas flow according to the requirements of the process gases flowing through the pump 7 or subsequent downstream abatement requirements.

The system controller 17 can provide automated control of the purge system 5. In particular, the system controller 17 outputs control signals based on signals received from one or more of the following: the processing tool 3, the gas sensor 21 and the pump motor 15. The purge system 5 can be switched to a low purge gas consumption mode when the control signals indicate a low gas throughput or benign chemistry of gases passing from chamber 20. The purge system 5 can be switched to a high purge gas consumption mode when signals indicate process gases or waste gases exhausted from chamber are corrosive, harsh, reactive or explosive.

At least in preferred embodiments, the purge system 5 according to the present invention can reduce costs through targeted purge supply according to the gases being pumped, as opposed to continuous purging even when purge gas is not needed.

The system controller 17 can also provide additional control functions. For example, the purge gas flow in the purge system 5 can be controlled to match process steps performed in the processing tool 3. A tool control signal can be output to the system controller 17 for this function. Moreover, the gas purge flow can be linked to the power profile of the vacuum pump 7. The system controller 17 can optionally operate in response to signal received from an abatement tool, for example to improve burn efficiency.

It will be appreciated that various changes and modifications can be made to the embodiment described herein without departing from the spirit and scope of the present invention. For example, the invention has been described with reference to a vacuum system but it could equally be employed in an abatement device. Such abatement devices are well known in the semiconductor manufacture sector and are generally used downstream of the vacuum pumps used to evacuate process tools. The abatement device is designed to neutralise hazardous substances exhausted by the process tool that pass through the vacuum system. Also, the invention could be implemented in integrated systems (both pump and abatement) where a single controller might be used for purge gas supplied to both pump and abatement systems.

## Claims

1. Apparatus (5) for supplying a purge gas to a multistage vacuum pump (7), the apparatus (5) comprising:
a gas inlet (25) in fluid communication with a plurality of gas outlets (27) for supplying gas to respective ports (13) of the multistage pump (7);
the gas outlets (27) having control orifices (41) for supplying gas to the respective ports (13) at proportionally fixed gas flow rates, wherein the control orifices in said gas outlets (27) have a fixed size ratio relative to each other;
the apparatus (5) further comprising a control module (17) for controlling the gas flow to the gas inlet (25) in response to a control signal, such that the total flow is varied while the flow through the separate gas outlets remains in the same fixed linear proportion to one another; and
further comprising at least one sensor (35) for generating said control signal, wherein said at least one sensor (35) is a pressure sensor in fluid communication with either the gas inlet (25) or one of said gas outlets (27).

2. Apparatus (5) as claimed in claim 1 further comprising fixed and/or variable restrictors (41) for defining the orifices in said gas outlets.

3. Apparatus (5) as claimed in any one of claims 1 or 2, wherein the control module (17) is operable to adjust the pressure of gas supplied to the gas inlet.

4. Apparatus (5) as claimed in any one of claims 1 to 3, wherein the control module (17) comprises a variable restrictor (37) for varying the gas flow rate through the gas inlet (25).

5. Apparatus (5) as claimed in any one of the preceding claims, wherein the control signal is received from a processing tool (3) upstream of the multistage pump (7); and/or a pump controller (17).

6. A pump system (1) comprising apparatus (5) as claimed in any one of the preceding claims, the pump system (1) further comprising:
a multistage pump (7) having a pump inlet (9), a plurality of ports (17) and a pump exhaust (11); and a pump controller (17) for controlling operation of the pump (7);
wherein the gas outlets (27) from the apparatus are connected to respective ports (13) of the multistage pump (7).

7. A pump system (1) as claimed in claim 6, wherein the pump controller (17) is configured to output the control signal in response to one or more of the following:
a) a pressure sensor in fluid communication with the pump inlet (9); and
b) a pressure sensor in fluid communication with the pump exhaust (11).

8. A pump system (1) as claimed in claim 6 or claim 7 further comprising a processing tool (3) having a tool controller and a conduit (31) in fluid communication with the pump inlet (9).

9. A pump system (1) as claimed in claim 8, wherein the tool controller generates the control signal in response to an operating mode of the processing tool (3).

10. A method for supplying a purge gas in a pump system (1) to a plurality of ports of the pump at proportionally fixed gas flow rates, the pump system (1) comprising a multistage vacuum pump (7) and a purge apparatus (5) having an inlet (25) and a plurality of gas outlets (27) in fluid communication with respective ports (13) of the multistage vacuum pump (7); wherein the gas outlets (27) have control orifices (41) with a fixed size ratio relative to each other for supplying gas at said proportionally fixed gas flow rates; wherein the method comprises controlling the supply of purge gas to said inlet (25) in response to a control signal from at least one sensor, such that the total flow is varied while the flow through the separate gas outlets remains in the same fixed linear proportion to one another, wherein said at least one sensor (35) is a pressure sensor in fluid communication with either the gas inlet (25) or one of said gas outlets (27).

## Patentansprüche

1. Vorrichtung (5) zum Zuführen eines Spülgases zu einer mehrstufigen Vakuumpumpe (7), wobei die Vorrichtung (5) Folgendes aufweist:
einen Gaseinlass (25) in Fluidverbindung mit einer Mehrzahl von Gasauslässen (27) zum Zuführen von Gas zu entsprechenden Anschlüssen (13) der mehrstufigen Pumpe (7);
wobei die Gasauslässe (27) Steueröffnungen (41) zum Zuführen von Gas zu den entsprechenden Anschlüssen (13) mit proportional festgelegten Gasdurchflussraten haben, wobei die Steueröffnungen in den Gasauslässen (27) ein festes Größenverhältnis relativ zueinander haben;
wobei die Vorrichtung (5) ferner ein Steuermodul (17) zum Steuern des Gasflusses zu dem Gaseinlass (25) in Reaktion auf ein Steuersignal aufweist, so dass der Gesamtdurchfluss variiert wird, während der Durchfluss durch die separaten Gasauslässe im selben festen linearen Verhältnis zueinander bleibt; und
ferner mit mindestens einem Sensor (35) zum Erzeugen des Steuersignals, wobei der mindestens eine Sensor (35) ein Drucksensor ist, der entweder mit dem Gaseinlass (25) oder einem der Gasauslässe (27) in Fluidverbindung steht.

2. Vorrichtung (5) nach Anspruch 1, die ferner feste und/oder variable Drosseln (41) zum Definieren der Öffnungen in den Gasauslässen umfasst.

3. Vorrichtung (5) nach einem der Ansprüche 1 oder 2, wobei das Steuermodul (17) zum Einstellen des Drucks von Gas betreibbar ist, das dem Gaseinlass zugeführt wird.

4. Vorrichtung (5) nach einem der Ansprüche 1 bis 3, wobei das Steuermodul (17) eine variable Drossel (37) zur Veränderung der Gasdurchflussrate durch den Gaseinlass (25) aufweist.

5. Vorrichtung (5) nach einem der vorangehenden Ansprüche, wobei das Steuersignal von einem der mehrstufigen Pumpe (7) vorgeschalteten Verarbeitungswerkzeug (3) und/oder einer Pumpensteuerung (17) empfangen wird.

6. Pumpensystem (1), das eine Vorrichtung (5) nach einem der vorangehenden Ansprüche aufweist, wobei das Pumpensystem (1) ferner Folgendes aufweist:
eine mehrstufige Pumpe (7) mit einem Pumpeneinlass (9), einer Mehrzahl von Anschlüssen (17) und einem Pumpenaustritt (11); und eine Pumpensteuerung (17) zum Steuern des Betriebs der Pumpe (7);
wobei die Gasauslässe (27) aus der Vorrichtung mit entsprechenden Anschlüssen (13) der mehrstufigen Pumpe (7) verbunden sind.

7. Pumpensystem (1) nach Anspruch 6, wobei die Pumpensteuerung (17) so konfiguriert ist, dass sie das Steuersignal als Reaktion auf eines oder mehreres von Folgendem ausgibt:
a) einen Drucksensor in Fluidverbindung mit dem Pumpeneinlass (9) und
b) einen Drucksensor in Fluidverbindung mit dem Pumpenaustritt (11).

8. Pumpensystem (1) nach Anspruch 6 oder Anspruch 7, das ferner ein Verarbeitungswerkzeug (3) mit einer Werkzeugsteuerung und einer Leitung (31) in Fluidverbindung mit dem Pumpeneinlass (9) umfasst.

9. Pumpensystem (1) nach Anspruch 8, wobei die Werkzeugsteuerung das Steuersignal in Abhängigkeit von einem Betriebsmodus des Verarbeitungswerkzeugs (3) erzeugt.

10. Verfahren zum Zuführen eines Spülgases in einem Pumpensystem (1) zu einer Mehrzahl von Anschlüssen der Pumpe mit proportional festgelegten Gasdurchflussraten, wobei das Pumpensystem (1) eine mehrstufige Vakuumpumpe (7) und eine Spülvorrichtung (5) mit einem Einlass (25) und einer Mehrzahl von Gasauslässen (27) in Fluidverbindung mit entsprechenden Anschlüssen (13) der mehrstufigen Vakuumpumpe (7) aufweist; wobei die Gasauslässe (27) Steueröffnungen (41) mit einem festen Größenverhältnis relativ zueinander zum Zuführen von Gas mit den proportional festgelegten Gasdurchflussraten haben; wobei das Verfahren ein Steuern der Zufuhr von Spülgas zu dem Einlass (25) in Reaktion auf ein Steuersignal von mindestens einem Sensor umfasst, so dass der Gesamtdurchfluss variiert wird, während der Durchfluss durch die separaten Gasauslässe im selben festen linearen Verhältnis zueinander bleibt, wobei der mindestens eine Sensor (35) ein Drucksensor ist, der entweder mit dem Gaseinlass (25) oder einem der Gasauslässe (27) in Fluidverbindung steht.

## Revendications

1. Appareil (5) pour fournir un gaz de purge à une pompe à vide à étages multiples (7), l'appareil (5) comprenant :
une entrée de gaz (25) en communication fluidique avec une pluralité de sorties de gaz (27) pour fournir un gaz à des trous (13) respectifs de la pompe à étages multiples (7) ;
les sorties de gaz (27) ayant des orifices de commande (41) pour fournir un gaz aux trous (13) respectifs à différentes vitesses d'écoulement de gaz proportionnellement fixes, dans lequel les orifices de commande dans lesdites sorties de gaz (27) ont un rapport de taille fixe relativement les uns aux autres ;
l'appareil (5) comprenant en outre un module de commande (17) pour commander l'écoulement de gaz vers l'entrée de gaz (25) en réponse à un signal de commande, de telle sorte que l'écoulement total soit varié alors que l'écoulement à travers les sorties de gaz séparées reste dans la même proportion linéaire fixe, les unes par rapport aux autres ; et
dans lequel ledit au moins un capteur (35) est un capteur de pression en communication fluidique avec l'entrée de gaz (25) ou une desdites sorties de gaz (27).

2. Appareil (5) selon la revendication 1, comprenant en outre des étrangleurs fixes et/ou variables (41) pour définir les orifices dans lesdites sorties de gaz.

3. Appareil (5) selon l'une quelconque des revendications 1 ou 2, dans lequel le module de commande (17) est utilisable pour ajuster la pression d'un gaz fourni à l'entrée de gaz.

4. Appareil (5) selon l'une quelconque des revendications 1 à 3, dans lequel le module de commande (17) comprend un étrangleur variable (37) pour varier la vitesse d'écoulement de gaz à travers l'entrée de gaz (25).

5. Appareil (5) selon l'une quelconque des revendications précédentes, dans lequel le signal de commande est reçu à partir d'un outil de traitement (3) en amont de la pompe à étages multiples (7) ; et/ou d'un dispositif de commande de pompe (17).

6. Système à pompe (1) comprenant un appareil (5) selon l'une quelconque des revendications précédentes, le système de pompe (1) comprenant en outre :
une pompe à étages multiples (7) ayant une entrée de pompe (9), une pluralité de trous (17) et une ouverture de refoulement de pompe (11) ; et
un dispositif de commande de pompe (17) pour commander le fonctionnement de la pompe (7) ;
dans lequel les sorties de gaz (27) de l'appareil sont raccordées à des trous (13) respectifs de la pompe à étages multiples (7).

7. Système à pompe (1) selon la revendication 6, dans lequel le dispositif de commande de pompe (17) est configuré pour produire en sortie le signal de commande en réponse à un ou plusieurs de ce qui suit :
a) un capteur de pression en communication fluidique avec l'entrée de pompe (9) ; et
b) un capteur de pression en communication fluidique avec l'ouverture de refoulement de pompe (11).

8. Système à pompe (1) selon la revendication 6 ou la revendication 7, comprenant en outre un outil de traitement (3) ayant une unité de commande d'outil et un conduit (31) en communication fluidique avec l'entrée de pompe (9).

9. Système à pompe (1) selon la revendication 8, dans lequel l'unité de commande d'outil génère le signal de commande en réponse à un mode de fonctionnement de l'outil de traitement (3).

10. Procédé pour fournir un gaz de purge dans un système de pompe (1) à une pluralité de trous de la pompe à différentes vitesses d'écoulement de gaz proportionnellement fixes, le système de pompe (1) comprenant une pompe à vide à étages multiples (7) et un appareil de purge (5) ayant une entrée (25) et une pluralité de sorties de gaz (27) en communication fluidique avec des trous (13) respectifs de la pompe à vide à étages multiples (7) ; dans lequel les sorties de gaz (27) ont des orifices de commande (41) avec un rapport de taille fixe relativement les uns aux autres pour fournir un gaz, auxdites vitesses d'écoulement de gaz proportionnellement fixes ; dans lequel le procédé comprend la commande de l'alimentation en gaz de purge à ladite entrée (25) en réponse à un signal de commande provenant d'au moins un capteur, de telle sorte que l'écoulement total soit varié alors que l'écoulement à travers les sorties de gaz séparées reste dans la même proportion linéaire fixe, les unes par rapport aux autres, dans lequel ledit au moins un capteur (35) est un capteur de pression en communication fluidique avec l'entrée de gaz (25) ou une desdites sorties de gaz (27).
